# EUROPÄISCHE PATENTSCHRIFT

(11) **EP 2 847 802 B1**
(45) Veröffentlichungstag und Bekanntmachung des Hinweises auf die Patenterteilung: **14.02.2018**
(21) Anmeldenummer: 13720827.8
(22) Anmeldetag: 15.04.2013
(51) Int. Cl.: H01L 35/06, H01L 35/34

(54) **HALBLEITERELEMENT FÜR EIN THERMOELEKTRISCHES MODUL UND THERMOELEKTRISCHES MODUL**
SEMICONDUCTOR ELEMENT FOR A THERMOELECTRIC MODULE, AND THERMOELECTRIC MODULE
ÉLÉMENT SEMI-CONDUCTEUR POUR UN MODULE THERMOÉLECTRIQUE ET MODULE THERMOÉLECTRIQUE

(30) Priorität: 07.05.2012 DE 102012103968
(43) Veröffentlichungstag der Anmeldung: 18.03.2015
(73) Patentinhaber: Continental Automotive GmbH, 30165 Hannover (DE)
(72) Erfinder: BRÜCK, Rolf, 51429 Bergisch Gladbach (DE); LIMBECK, Sigrid, 53804 Much (DE)
(86) Internationale Anmeldenummer: PCT/EP2013/057755
(87) Internationale Veröffentlichungsnummer: WO 2013/167348

(56) Entgegenhaltungen:
- US-A- 3 238 614
- US-A- 3 432 365

## Beschreibung

Die vorliegende Erfindung betrifft ein Halbleiterelement und ein thermoelektrisches Modul.

Das Abgas aus einer Verbrennungskraftmaschine eines Kraftfahrzeugs besitzt thermische Energie, welche mittels eines thermoelektrischen Generators in elektrische Energie umgewandelt werden kann, bspw. um eine Batterie oder einen anderen Energiespeicher zu füllen und/oder elektrischen Verbrauchern die benötigte Energie direkt zuzuführen. Damit wird das Kraftfahrzeug mit einem besseren energetischen Wirkungsgrad betrieben, und es steht für den Betrieb des Kraftfahrzeugs Energie in größerem Umfang zur Verfügung.

Ein solcher thermoelektrischer Generator weist zumindest ein thermoelektrisches Modul auf. Thermoelektrische Module umfassen z. B. wenigstens zwei Halbleiterelemente (p-dotiert und n-dotiert), die auf ihrer Oberseite und Unterseite (hin zur Heißseite bzw. Kaltseite) wechselseitig mit elektrisch leitenden Brücken versehen sind und die die kleinste thermoelektrische Einheit bzw. ein thermoelektrisches Element bilden. Thermoelektrische Materialien sind von einer Art, dass diese effektiv thermische Energie in elektrische Energie umwandeln können (Seebeck-Effekt) und umgekehrt (Peltier-Effekt). Wird ein Temperaturgefälle beidseits der Halbleiterelemente bereitgestellt, so bildet sich zwischen den Enden der Halbleiterelemente ein Spannungspotential aus. Die Ladungsträger auf der heißeren Seite werden durch die höhere Temperatur vermehrt in das Leitungsband angeregt. Durch den dabei erzeugten Konzentrationsunterschied im Leitungsband diffundieren Ladungsträger auf die kältere Seite des Halbleiterelements, wodurch die Potentialdifferenz entsteht. In einem thermoelektrischen Modul sind bevorzugt zahlreiche Halbleiterelemente elektrisch in Reihe geschaltet. Damit sich die generierten Potentialdifferenzen der seriellen Halbleiterelemente nicht gegenseitig aufheben, sind stets wechselweise Halbleiterelemente mit unterschiedlichen Majoritätsladungsträgern (n-dotiert und p-dotiert) in direkten elektrischen Kontakt gebracht. Mittels eines angeschlossenen Lastwiderstands kann der Stromkreis geschlossen und somit elektrische Leistung abgegriffen werden.

Um eine dauerhafte Einsatzfähigkeit der Halbleiterelemente zu gewährleisten, wird zwischen den elektrisch leitenden Brücken und dem thermoelektrischen Material regelmäßig eine Diffusionsbarriere angeordnet, die ein Diffundieren von in den elektrischen Brücken enthaltenem Material in das thermoelektrische Material verhindert und damit einem Effektivitätsverlust bzw. ein funktionelles Versagen des Halbleitermaterials bzw. des thermoelektrischen Elements verhindert. Der Aufbau von thermoelektrischen Modulen bzw. der Halbleiterelemente erfolgt üblicherweise durch den Zusammenbau der einzelnen Komponenten thermoelektrisches Material, Diffusionsbarriere, elektrisch leitende Brücken, Isolierung und ggf. weiteren Gehäuseelementen zu einem thermoelektrischen Modul, das von einem heißen bzw. kalten Medium überströmt wird. Dieser Zusammenbau zahlreicher einzelner Komponenten erfordert auch eine genaue Abstimmung der einzelnen Bauteiltoleranzen und eine Berücksichtigung der Wärmeübergänge von der Heißseite zur Kaltseite sowie der hinreichenden Kontaktierung der elektrisch leitenden Brücken, so dass ein Stromfluss durch das thermoelektrische Modul erzeugt werden kann. Gerade im Hinblick auf die Bereitstellung von Thermoelektrischen Generatoren in Kraftfahrzeugen und auf die dort vorliegenden Stückzahlen ist der Kostenfaktor eine wichtige Größe. Ein großer Teil der Kosten werden durch die teilweise sehr teuren Materialien verursacht, die zum Aufbau eines thermoelektrischen Generators verwendet werden.

Die US 3,238,614 ist auf die Verbindung eines thermoelektrischen Elements mit einem elektrischen Leiterelement gerichtet. Als elektrisches Leiterelement wird ein ferritischer Stahl vorgeschlagen.

Die US 3,432,365 A ist auf eine Anordnung von thermoelektrischen Elementen zur Bildung eines thermoelektrischen Generators gerichtet. Dabei wird ein ferritischer Stahl für ein elektrisches Kontaktmaterial vorgeschlagen.

Hiervon ausgehend ist es Aufgabe der hier vorliegenden Erfindung, die im Bezug auf den Stand der Technik geschilderten Probleme zumindest teilweise zu lösen. Insbesondere soll ein Halbleiterelement angegeben werden, das für vielseitige Einsatzfälle geeignet ist, das eine verbesserte Beständigkeit gegen Temperaturwechselbeanspruchungen aufweist, und das einen möglichst einfachen und kostengünstigen Aufbau eines thermoelektrischen Moduls ermöglicht.

Diese Aufgaben werden gelöst mit einem Halbleiterelement gemäß den Merkmalen des Patentanspruchs 1 und mit einem thermoelektrischen Modul gemäß Patentanspruch 8. Vorteilhafte Ausgestaltungen des erfindungsgemäßen Halbleiterelements und des thermoelektrischen Moduls sind in den abhängig formulierten Patentansprüchen angegeben. Die in den Patentansprüchen einzeln aufgeführten Merkmale sind in beliebiger, technologisch sinnvoller Weise miteinander kombinierbar und zeigen weitere Ausgestaltungen der Erfindung auf. Die Beschreibung, insbesondere im Zusammenhang mit den Figuren, erläutert die Erfindung weiter und führt ergänzende Ausführungsbeispiele der Erfindung an.

Das erfindungsgemäße Halbleiterelement weist zumindest ein thermoelektrisches Material und ein erstes Rahmenteil auf, wobei diese kraftschlüssig miteinander verbunden sind wobei das erste Rahmenteil einen elektrischen Stromleiter bildet und aus einem ferritischem Stahl besteht.

Das Halbleiterelement stellt hier also die kleinste Baueinheit dar und ist bereits mit dem ersten Rahmenteil kraftschlüssig und unverlierbar verbunden. Kraftschlüssig bedeutet hier insbesondere, dass die gegenseitige Verschiebung verhindert wird, solange die durch die Haftreibung bewirkte Gegen-Kraft nicht überschritten wird.

Als ein ferritischer Stahl wird eine kristallographische Modifikation des Eisens verstanden, die ein kubisch-raumzentriertes Kristallgitter bildet. Der hier vorgeschlagene ferritische Stahl weist neben einer guten elektrischen Leitfähigkeit insbesondere auch eine gute Wärmeleitfähigkeit auf und gleichzeitig eine geringe Wärmeausdehnung.

Insbesondere wird zwischen dem Halbleitermaterial und dem ersten Rahmenteil zusätzlich eine Diffusionsbarriere angeordnet, so dass Legierungselemente aus dem Rahmenteil nicht in das Halbleitermaterial hinein diffundieren und dessen Effektivität hinsichtlich der Umwandlung von Wärmeenergie in elektrische Energie beeinträchtigen. Diese Diffusionsbarriere ist insbesondere aus Nickel oder Molybdän auszuführen. Bevorzugt ist aber keine zusätzliche Diffusionsbarriere zwischen Halbeleitermaterial und dem ersten Rahmenteil erforderlich. Gleichzeitig stellt das erste Rahmenteil einen elektrischen Stromleiter zur Verfügung, so dass das erste Rahmenteil eines Halbleiterelements auch mit benachbarten Halbleiterelementen oder deren erste Rahmenteilen direkt verbindbar ist und somit ein durch das thermoelektrische Modul erzeugter elektrischer Strom insbesondere ausschließlich durch die Rahmenteile und die Halbleiterelemente (sowie die Diffusionsbarrieren) des thermoelektrischen Moduls fließt. Insbesondere sind das Halbleiterelement und das erste Rahmenteil miteinander zumindest teilweise formschlüssig oder sogar stoffschlüssig verbunden. Formschlüssig bedeutet hier insbesondere das eine relative Bewegung der Verbindungspartner in zumindest einer Richtung, bevorzugt in jeder Richtung, nicht möglich ist, da die Verbindungspartner einander im Weg sind. Stoffschlüssig bedeutet hier insbesondere, dass die Verbindungspartner durch atomare oder molekulare Kräfte zusammengehalten werden.

Als thermoelektrisches Material sind insbesondere folgende Werkstoffe einsetzbar:
n-Typ: Bi₂Te₃; PbTe; Ba_{0,3}Co_{3,95}Ni_{0,05}Sb₁₂; Ba_{y}(Co,Ni)₄Sb₁₂; CoSb₃;
   Ba₈Ga₁₆Ge₃₀;
   La₂Te₃; SiGe; Mg₂(Si,Sn);
p-Typ: (Bi,Sb)₂Te₃; Zn₄Sb₃; TAGS; PbTe; SnTe; CeFe₄Sb₁₂; Yb₁₄MnSb₁₁; SiGe;
   Mg₂(Si,Sb).

Erfindungsgemäß weist der ferritische Stahl zumindest folgende Legierungsbestandteile auf:
- höchstens 0,025 Gew.-% Kohlenstoff (C),
- 21 bis 24 Gew.-% Chrom (Cr),
- 0,7 bis 1,5 Gew.-% Molybdän (Mo),
- höchstens 1 Gew.-% Niob (Nb),
- höchstens 78,3 Gew.-% Eisen (Fe).

Insbesondere kann der ferritische Stahl weitere Legierungsbestandteile enthalten, die jedoch jeweils einen Anteil von 1 Gew.-% nicht überschreiten, bevorzugt jeweils höchstens 0,2 Gew.-% betragen. Insbesondere ist vorgesehen, dass alle weiteren Legierungsbestandteile insgesamt höchstens 3 Gew.-% ausmachen, bevorzugt sogar nur höchstens 1 Gew.-%.

Der ferritische Stahl, insbesondere mit der oben angegebenen Legierungszusammensetzung, weist insbesondere eine Wärmeleitung von ca. 26 W/m°C [Watt/Meter*Grad Celsius] auf, gemessen bei 100°C. Insbesondere liegt in einem Bereich von 20 °C und 100 °C ein Wärmeausdehnungskoeffizient von ca. 10 * 10⁻⁶ (0.00001) pro Grad Kelvin [1/K] vor. Gleichzeitig weist der ferritische Stahl einen sehr guten Korrosionswiderstand auf, so dass eine hohe Beständigkeit der Eigenschaften des ersten Rahmenteils gewährleistet werden kann. Gegenüber den üblicherweise hier verwendeten Materialien für elektrisch leitende Brücken zwischen den Halbleiterelementen weist dieser ferritische Stahl auch einen deutlichen Kostenvorteil auf.

Eine besonders bevorzugte Legierungszusammensetzung des ferritischen Stahls wird nachfolgend angegeben:
- 0,006 Gew.-% Kohlenstoff (C),
- 22 Gew.-% Chrom (Cr),
- 1,0 Gew.-% Molybdän (Mo),
- 0,3 Gew.-% Niob (Nb),
- Rest Eisen (Fe),
- wobei "Verunreinigungen" nur mit einem Anteil von höchstens 1 Gew.-% vorliegen.

Eine besonders vorteilhafte Ausgestaltung des Halbleiterelements sieht ein zweites Rahmenteil für das Halbleiterelement vor, das auf einer Elementfläche des thermoelektrischen Materials angeordnet ist, die der Elementfläche gegenüberliegt, an der das erste Rahmenteil angeordnet ist. Dabei ist das thermoelektrische Material insbesondere nach Art eines Zylinders, Kubus, Barrens und/oder Kreisringsegments ausgeführt, wobei das erste Rahmenteil und das zweite Rahmenteil auf sich gegenüberliegenden Elementflächen des thermoelektrischen Materials angeordnet sind. Alle Ausführungen, die das erste Rahmenteil betreffen, gelten ohne Einschränkung auch für das zweite Rahmenteil und umgekehrt.

Gemäß einer weiteren vorteilhaften Ausgestaltung des Halbleiterelements sind das thermoelektrische Material, das erste Rahmenteil und das zweite Rahmenteil ringförmig, wobei das erste Rahmenteil auf einer inneren Umfangsfläche und das zweite Rahmenteil auf einer äußeren Umfangsfläche des thermoelektrischen Materials angeordnet sind. Insbesondere ist durch eine derartige Ausgestaltung ein rohrförmiges thermoelektrisches Modul herstellbar, bei dem die Halbleiterelemente hintereinander angeordnet werden und über erste Rahmenteile und zweite Rahmenteile jeweils wechselweise elektrisch miteinander verbunden sind.

Weiterhin wird vorgeschlagen, dass zumindest das erste Rahmenteil zwei voneinander beabstandete gegenüberliegende Flächen aufweist, wobei eine der Flächen eine dem thermoelektrischen Material zugewandte Anbindungsfläche ist und der Abstand der Flächen voneinander eine Dicke des ersten Rahmenteils definiert und diese Dicke 0,1 mm bis 1 mm [Millimeter], bevorzugt 0,2 bis 0,5 mm, beträgt. Insbesondere sind die durch das thermoelektrische Material voneinander beabstandeten ersten Rahmenteile und zweiten Rahmenteile 1 bis 5 mm [Millimeter] voneinander entfernt, d. h. die Materialstärke des thermoelektrischen Materials beträgt 1 bis 5 mm. Das zweite Rahmenteil kann gegebenenfalls ebenso ausgeführt sein.

Gemäß einer weiteren vorteilhaften Ausgestaltung des Halbleiterelements weist zumindest das erste Rahmenteil zwei voneinander beabstandete gegenüberliegende Kontaktflächen auf, deren Abstand eine erste Breite definieren. Dabei ist die erste Breite zumindest teilweise größer als eine zweite Breite des thermoelektrischen Materials, so dass das erste Rahmenteil an zumindest einer Seite des thermoelektrischen Materials übersteht. Die hier genannten Kontaktflächen dienen insbesondere der Kontaktierung von benachbart zueinander angeordneten Halbleiterelementen über deren Rahmenteile. Die Erstreckung des ersten Rahmenteils mit einer ersten Breite und des thermoelektrischen Materials in einer zweiten Breite wird insbesondere in einer parallelen Richtung zueinander betrachtet, so dass durch die Definition, dass die erste Breite zumindest teilweise größer als die zweite Breite ist klargestellt wird, dass das erste Rahmenteil an zumindest einer Seite des thermoelektrischen Materials über dieses übersteht. Bevorzugt wird dabei das erste Rahmenteil an zumindest einer Seite bündig zu dem thermoelektrischen Material angeordnet. Ganz besonders bevorzugt ist, dass dieser (einzelne) Überstand nur über einen geringen Teil der Erstreckung des ersten Rahmenteils vorgesehen ist, insbesondere nur über 30 % oder sogar nur 20 % der Erstreckung (in Umfangsrichtung). Das zweite Rahmenteil kann gegebenenfalls ebenso ausgeführt sein.

Es kann auch vorgesehen sein, dass zumindest das erste Rahmenteil zusätzlich an zumindest einer weiteren Seite gegenüber dem thermoelektrischen Material übersteht. Eine solche Ausgestaltung ist insbesondere dann vorteilhaft, wenn eine Verbindung der ersten Rahmenteile über die Kontaktflächen erfolgt, so dass es im Falle eines Verschweißens, Verlötens oder Verklebens der Kontaktflächen von nebeneinander angeordneten Halbleiterelementen miteinander nicht zu einer Beschädigung oder Verunreinigung des thermoelektrischen Materials kommt, wodurch die Effektivität hinsichtlich der Umwandlung von Wärmeenergie in elektrische Energie beeinträchtigt werden könnte. Das zweite Rahmenteil kann gegebenenfalls ebenso ausgeführt sein.

Gemäß einer weiteren vorteilhaften Ausgestaltung des Halbleiterelements weist zumindest das erste Rahmenteil eine Beschichtung auf, die zumindest auf der dem thermoelektrischen Material zugewandten Anbindungsfläche angeordnet ist. Das zweite Rahmenteil kann gegebenenfalls ebenso ausgeführt sein. Diese Beschichtung umfasst insbesondere ein Lot und/oder ein Material zur Erhöhung der Verbindungsflächen von thermoelektrischem Material und erstem/zweitem Rahmenteil. Hier muss insbesondere das Lot zusätzlich die Eigenschaften einer Diffusionsbarriere aufweisen, da es zwischen thermoelektrischem Material und erstem/zweiten Rahmenteil angeordnet ist. Durch die Beschichtung wird die Verbindung zwischen dem ersten/zweiten Rahmenteil und thermoelektrischem Material möglich bzw. mit einer möglichst hohen Festigkeit ausgeführt. Somit kann auch die wärmeleitende Kontaktierung zwischen dem erstem/zweiten Rahmenteil und thermoelektrischem Material verbessert werden bzw. sichergestellt sein, so dass die Effektivität des Halbleiterelements bzw. des eine Vielzahl von Halbleiterelementen aufweisenden thermoelektrischen Moduls gewährleistet ist. Eine für diesen Zweck eingesetzte Beschichtung umfasst insbesondere Lot.

Weiterhin wird vorgeschlagen, dass zumindest das erste Rahmenteil zumindest auf der dem thermoelektrischen Material zugewandten Anbindungsfläche wenigstens teilweise eine Oberflächenstruktur aufweist, die mindestens eines der folgenden Elemente umfasst:
- Nut,
- Absatz,
- Erhebung,
- Rauhigkeit Rz von mindestens 12 µm.

Durch diese Oberflächenstruktur kommt es insbesondere zu einem Formschluss von thermoelektrischem Material über das mindestens eine Element hin zu dem ersten Rahmenteil. Durch das Element wird die Verbindung zwischen thermoelektrischem Material und dem ersten Rahmenteil hinsichtlich der Verbindungsfestigkeit verbessert. Das zweite Rahmenteil kann gegebenenfalls ebenso ausgeführt sein.

Eine Nut umfasst hier eine Vertiefung innerhalb des ersten Rahmenteils, die sich von einem Absatz dahingehend unterscheidet, dass bei einem (umlaufenden) Absatz die Vertiefung sich bis zu einer Kontaktfläche erstreckt, so dass das erste Rahmenteil auf ein thermoelektrisches Material aufschiebbar wäre. Die hier angegeben Erhebung ist im Gegensatz zu der Nut und dem Absatz ein Fortsatz des Rahmenteils, der sich in das thermoelektrische Material hinein erstreckt und damit einen Formschluss zwischen thermoelektrischem Material und dem erstem Rahmenteil ermöglicht.

Die hier definierte Rauhigkeit Rz wird üblicherweise nach DIN 4768 ermittelt, wobei hier ein Wert von zumindest 12 µm [Mikrometer], insbesondere zumindest 20 µm vorliegt, so dass eine große Oberfläche zur Verbindung von thermoelektrischem Material und erstem Rahmenteil vorliegt.

Ein Verfahren zur Herstellung eines Halbleiterelements weist zumindest die folgenden Schritte auf:
a) Bereitstellen zumindest eines ersten Rahmenteils,
b) Anordnen eines thermoelektrischen Materials an einer Anbindungsfläche des ersten Rahmenteils,
c) Verpressen zumindest des ersten Rahmenteils und des thermoelektrischen Materials, so dass die beiden eine kraftschlüssige Verbindung eingehen.

Das Verfahren ist insbesondere geeignet zur Herstellung eines hier erfindungsgemäß beschriebenen Halbleiterelements.

Die einzelnen Schritte werden regelmäßig in der hier angegebenen Reihenfolge ausgeführt, wobei ggf. mehrere Halbleiterelemente gemeinsam hergestellt werden können. Im Hinblick auf das Verfahren ist anzumerken, dass in Schritt a) ggf. auch ein zweites Rahmenteil bereitgestellt werden kann, so dass dann in Schritt b) das thermoelektrische Material zwischen den Anbindungsflächen beider Rahmenteile angeordnet und danach mit diesen verpresst wird.

Weiterhin wird hier ein thermoelektrisches Modul vorgeschlagen, dass zumindest Halbleiterelemente aufweist, die über elektrisch leitende Brücken miteinander verbunden sind, so dass thermoelektrische Elemente gebildet werden, wobei zumindest eine elektrisch leitende Brücke einen ferritischen Stahl aufweist. Im Hinblick auf die Ausgestaltungen dieses ferritischen Stahls wird auf die vorstehenden Aspekte zum ersten Rahmenteil vollständig Bezug genommen.

Bei der erfindungsgemäßen Ausgestaltung des thermoelektrischen Moduls weist die elektrisch leitende Brücke einen ferritischen Stahl mit zumindest folgenden Legierungsbestandteilen auf:
- höchstens 0,025 Gew.-% Kohlenstoff (C),
- 21 bis 24 Gew.-% Chrom (Cr),
- 0,7 bis 1,5 Gew.-% Molybdän (Mo),
- höchstens 1 Gew.-% Niob (Nb),
- höchstens 78,3 Gew.-% Eisen (Fe).

Insbesondere weist das thermoelektrische Modul zumindest zwei erfindungsgemäße Halbleiterelemente auf. Dabei sind die Halbleiterelemente in dem thermoelektrischen Modul so nebeneinander angeordnet, dass sich Rahmenteile benachbarter Halbleiterelemente kontaktieren und an dieser Kontaktierung stoffschlüssig miteinander verbunden sind.

Gemäß einer weiteren vorteilhaften Ausgestaltung des thermoelektrischen Moduls kontaktieren sich Rahmenteile benachbarter Halbleiterelemente an jeweils einer Kontaktfläche und sind an dieser Kontaktierung stoffschlüssig miteinander verbunden. Insbesondere wird durch eine derartige Ausgestaltung ein Stumpfstoß zwischen den benachbart angeordneten Halbleiterelementen realisiert, so dass diese in besonders einfacher Art miteinander verschweißt, verlötet oder verklebt werden können. Alternativ oder zusätzlich kontaktieren Rahmenteile benachbarter Halbleiterelemente an jeweils einer Kontaktfläche und sind an dieser Kontaktierung elastisch miteinander verbunden, insbesondere durch eine entsprechende Vulkanisierung und/oder Gummierung.

Bevorzugt kann die Ausbildung einer stoffschlüssigen Verbindung benachbart angeordneter Halbleiterelemente durch Schweißen, insbesondere durch Laserschweißen erfolgen.

Insbesondere ist bei dem thermoelektrischen Modul zumindest ein erstes Rahmenteil unmittelbar mit einem heißen Medium wärmeleitend verbunden oder zumindest ein zweites Rahmenteil nur über eine elektrische Isolierung mit einem kalten Medium wärmeleitend verbunden. Ebenso können beide Merkmale gemeinsam vorgesehen sein.

Insbesondere wird hier als heißes Medium das Abgas einer Verbrennungskraftmaschine angesehen, das ein thermoelektrisches Modul überströmt. Insbesondere wird die dem Abgas zugewandte Oberfläche des thermoelektrischen Moduls zumindest durch eine Mehrzahl von ersten Rahmenteilen gebildet. Die ersten Rahmenteile sind untereinander in elektrisch leitender Weise stoffschlüssig miteinander verbunden. Wechselweise sind die Halbleiterelemente aber auch elektrisch gegeneinander isoliert ausgeführt, so dass der elektrische Strom wechselweise von einer Heißseite zu einer Kaltseite über n-dotierte und p-dotierte Halbleiterelemente geleitet wird. Die ersten Rahmenteile erzeugen einen elektrischen Strompfad entlang des thermoelektrischen Moduls und bilden dabei die Außenfläche des thermoelektrischen Moduls, die eine möglichst verlustarme Wärmeübertragung von einem heißen Medium auf die Halbleiterelemente ermöglichen soll. Da die zumindest ersten Rahmenteile somit das Gehäuse des thermoelektrischen Moduls an der Heißseite bilden, kann hier auf eine elektrische Isolierung der elektrisch leitenden ersten Rahmenteile gegenüber dem Abgas verzichtet werden. Dadurch wird der übliche Aufbau aus Gehäuse, elektrischer Isolierung, elektrisch leitenden Strompfaden, Diffusionsbarriere, thermoelektrischem Material signifikant vereinfacht. Die benachbart zueinander angeordneten Halbleiterelemente können insbesondere an ihren einander zugewandten Kontaktflächen elektrische Isolationselemente aufweisen, die eine Abdichtung des thermoelektrischen Moduls gegenüber dem Abgas ermöglichen und andererseits die ersten Rahmenteile gegeneinander elektrisch isolieren.

Entsprechend werden auch zweite Rahmenteile vorgeschlagen, die insbesondere das thermoelektrische Modul gegenüber einem kalten Medium abgrenzen. Das kalte Medium ist hier insbesondere eine Flüssigkeit. Eine elektrische Isolierung sollte gleichzeitig eine gute Wärmeleitung ermöglichen, so dass der Wirkungsgrad des thermoelektrischen Moduls hinsichtlich der Umwandlung von im Abgas enthaltener Wärmeenergie zu elektrischer Energie nicht eingeschränkt wird. Als elektrische Isolierung ist z. B. eine Folie vorgesehen, die in einfacher Weise auf die entsprechende Oberfläche des thermoelektrischen Moduls aufgebracht werden kann. Alternativ oder zusätzlich kann als elektrische Isolierung ein Schrumpfschlauch, insbesondere auf der dem kalten Medium zugewandten Seite der zweiten Rahmenteile vorgesehen sein. Eine elektrische Isolierung kann auf den Rahmenteilen außen und/oder innen aufgetragen sein, insbesondere außen, bevorzugt in den die Außenfläche des thermoelektrischen Moduls bildenden Bereichen der Rahmenteile.

Die hier vorgeschlagenen Halbleiterelemente und thermoelektrischen Module sind insbesondere für thermoelektrische Generatoren geeignet, die für Kraftfahrzeuge verwendet werden, und die die Wärmeenergie eines Abgases einer Verbrennungskraftmaschine in elektrische Energie umwandeln sollen. Die im Zusammenhang mit dem ferritischen Stahl für das erste Rahmenteil beschriebenen Ausgestaltungen sind insbesondere auf die elektrischen leitenden Brücken des thermoelektrischen Moduls übertragbar.

Die Erfindung sowie das technische Umfeld werden nachfolgend anhand der Figuren näher erläutert. Es ist darauf hinzuweisen, dass die Figuren besonders bevorzugte Ausführungsvarianten der Erfindung aufzeigen, diese jedoch nicht darauf beschränkt ist. Es zeigen schematisch:
- Fig. 1:: ein Halbleiterelement;
- Fig. 2:: ein erstes Rahmenteil;
- Fig. 3:: ein zweites Rahmenteil;
- Fig. 4:: ein thermoelektrisches Modul;
- Fig. 5:: eine erste Anordnung von Halbleiterelementen;
- Fig. 6:: eine zweite Anordnung von Halbleiterelementen.

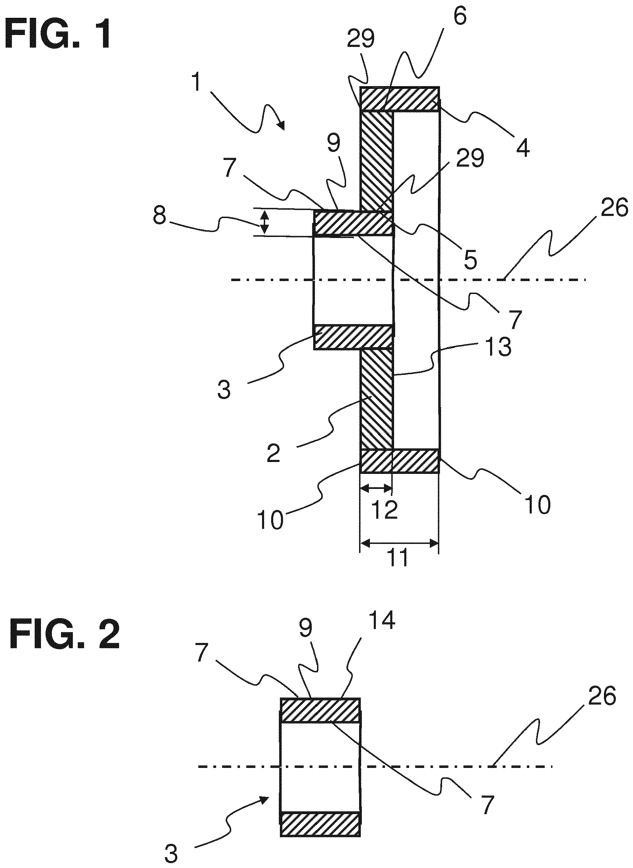

Fig. 1 zeigt ein ringförmiges Halbleiterelement 1 mit einem thermoelektrischen Material 2 und einem auf der inneren Umfangsfläche 5 des thermoelektrischen Materials 2 angeordnetem ersten Rahmenteil 3. Auf der äußeren Umfangsfläche 6 des thermoelektrischen Materials 2 ist ein zweites Rahmenteil 4 angeordnet. Auch wenn hier die Bezeichnung "erstes Rahmenteil" für das innere Rahmenteil und die Bezeichnung "zweites Rahmenteil" für das äußere Rahmenteil verwendet wird, ist eine solche Zuordnung nicht zwingend für andere Ausführungsvarianten der Erfindung.

Die äußere Umfangsfläche 6 ist die Elementfläche 29 des thermoelektrischen Materials 2, die der Elementfläche 29 des thermoelektrischen Materials 2 gegenüberliegt, an der dieses mit dem ersten Rahmenteil 3 verbunden ist. Das erste Rahmenteil 3 weist zwei gegenüberliegende Flächen 7 auf, wobei an der dem thermoelektrischen Material 2 gegenüberliegenden Fläche 7 eine Anbindungsfläche 9 gebildet ist. Zwischen den gegenüberliegenden Flächen 7 wird eine Dicke 8 des ersten Rahmenteils 3 gebildet. Das zweite Rahmenteil 4 weist zwei einander gegenüberliegende Kontaktflächen 10 auf, zwischen denen sich eine erste Breite 11 des zweiten Rahmenteils 4 erstreckt. In einer entsprechenden parallelen Richtung weist das thermoelektrische Material 2 eine zweite Breite 12 auf, die hier geringer ist als die erste Breite 11. Entsprechend steht das zweite Rahmenteil 4 in Richtung der Mittelachse 26 über das thermoelektrische Material 2 an einer Seite 13 des thermoelektrischen Materials 2 über. Ein entsprechender Überstand über das thermoelektrische Material 2 bildet sich in einer entgegen gesetzten Richtung gegenüber dem zweiten Rahmenteil 4 auch am ersten Rahmenteil 3 in Richtung der Mittelachse 26 aus.

Fig. 2 zeigt ein ringförmiges erstes Rahmenteil 3 mit zwei einander gegenüberliegenden Flächen 7, wobei hier die äußere Fläche 7 eine Anbindungsfläche 9 bildet zur Anbindung des ersten Rahmenteils 3 an das thermoelektrische Material. Dabei ist zur Erhöhung der Verbindungsfestigkeit zwischen erstem Rahmenteil 3 und thermoelektrischen Material 2 eine Beschichtung 14 vorgesehen, die auf der Anbindungsfläche 9 aufgetragen ist.

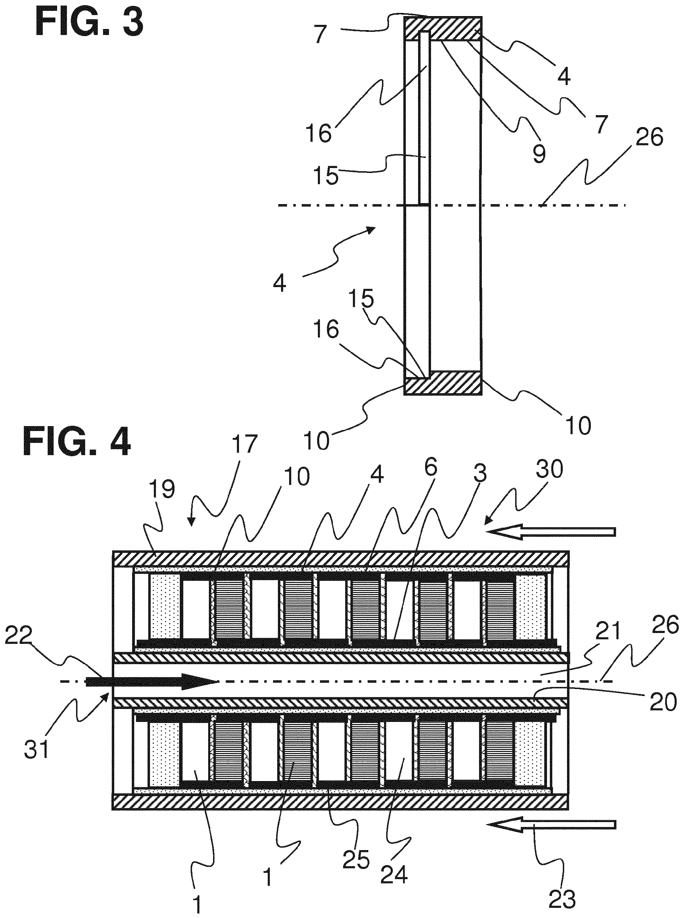

Fig. 3 zeigt ein zweites Rahmenteil 4 mit entsprechenden einander gegenüberliegenden Flächen 7, wobei hier die innere Umfangsfläche des ringförmigen zweiten Rahmenteils 4 die Anbindungsfläche 9 aufweist zur Anbindung des zweiten Rahmenteils 4 an das thermoelektrische Material. Auf der Anbindungsfläche 9 ist im oberen Teil der Fig. 3 ein Element 16 als Oberflächenstruktur 15 dargestellt, das hier als Nut ausgeführt ist. In diese Nut hinein erstreckt sich das thermoelektrische Material, so dass es zumindest in Richtung der Mittelachse 26 innerhalb des ringförmigen zweiten Rahmenteils 4 fixiert ist. Das thermoelektrische Material kann sich dabei in Richtung der Mittelachse 26 beidseitig der Nut innerhalb des zweiten Rahmenteils 4 erstrecken. In der unteren Hälfte der Fig. 3 ist als Oberflächenstruktur 15 das Element 16 als Absatz dargestellt, das zumindest in einer Richtung der Mittelachse 26 eine Fixierung des thermoelektrischen Materials erlaubt. Das thermoelektrische Material ist zwischen der ringförmigen Anbindungsfläche 9 und den seitlichen Kontaktflächen 10 angeordnet.

Fig. 4 zeigt ein thermoelektrisches Modul 17 mit einer Vielzahl von Halbleiterelementen 1. Diese Halbleiterelemente 1 sind ringförmig um ein Innenrohr 20 angeordnet und werden auf einer äußeren Umfangsfläche 6 durch ein Außenrohr 19 umschlossen. Das Innenrohr 20 bildet einen Kanal 21, durch den ein heißes Medium 22 entlang der Mittelachse 26 strömt. Auf der äußeren Umfangsfläche des Außenrohrs 19 wird das thermoelektrische Modul 17 von einem kalten Medium 23 überströmt. Dadurch bildet sich zwischen Außenrohr 19 und Innenrohr 20 ein Temperaturpotential aus, so dass durch die wechselweise auf der Kaltseite 30 bzw. Heißseite 31 elektrisch miteinander verbundenen Halbleiterelemente 1 ein elektrischer Strom durch das thermoelektrische Modul 17 in Folge des thermoelektrischen Effekts erzeugbar wird. An den Kontaktflächen 10 sind zweite Rahmenteile 4 bzw. erste Rahmenteile 3 miteinander elektrisch leitend verbunden. Die Rahmenteile 3, 4 können auch als elektrisch leitende Brücken 25 bezeichnet werden, über die die Halbleiterelemente zu thermoelektrischen Elementen 24 verbunden werden.

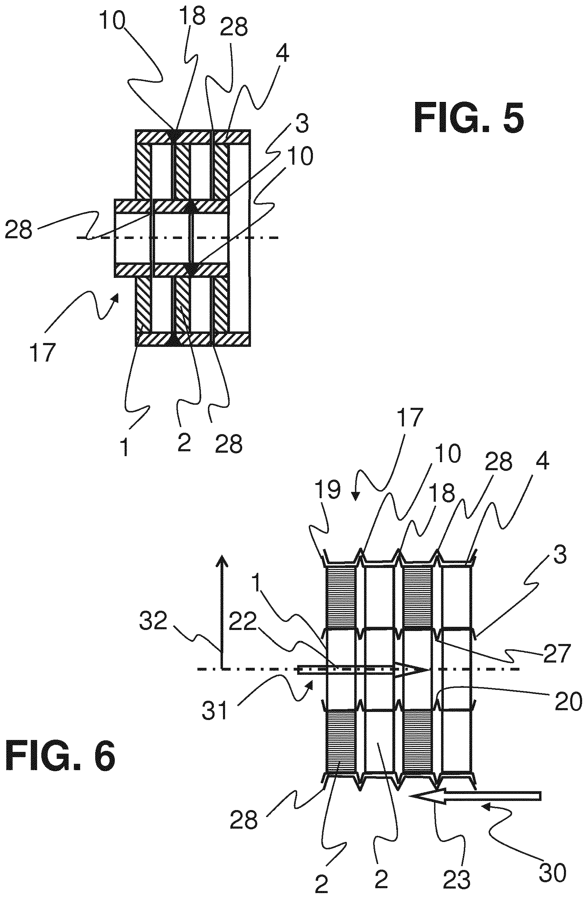

Fig. 5 zeigt eine erste Anordnung von Halbleiterelementen 1 zu einem thermoelektrischen Modul 17. Die hier entsprechend Fig. 1 aufgebauten Halbleiterelemente 1 sind wechselweise über erste Rahmenteile 3 bzw. zweite Rahmenteile 4 an Kontaktierungen 18 bildenden Kontaktflächen 10 miteinander stoffschlüssig verbunden. Entsprechend sind wechselweise zwischen jeweils benachbarten ersten Rahmenteilen 3 und jeweils benachbarten zweiten Rahmenteilen 4 elektrische Isolierungen 28 vorgesehen, die einen entsprechenden Strompfad durch das thermoelektrische Modul 17 erzeugen.

Fig. 6 zeigt eine zweite Anordnung von Halbleiterelementen 1 zu einem thermoelektrischen Modul 17. Dabei sind n- und p-dotierte thermoelektrische Materialien 2 über erste Rahmenteile 3 bzw. zweite Rahmenteile 4 über Kontaktierungen 18 bildende Kontaktflächen 10 elektrisch leitend miteinander verbunden bzw. an den Kontaktflächen 10 voneinander isoliert. Das thermoelektrische Modul 17 wird hier direkt auf der äußeren Oberfläche des thermoelektrischen Moduls 17, die durch die zweiten Rahmenteile 4 gebildet wird, von einem kalten Medium 23 überströmt. Die ringförmig umlaufend ausgebildeten und in einer radialen Richtung nach außen aufstehenden zweiten Rahmenteile 4 sind an Kontaktflächen 10 miteinander wechselweise elektrisch leitend oder elektrisch isoliert verbunden und bilden somit ein zusammenhängendes Außenrohr 19. Entsprechend bilden auf der Innenseite des thermoelektrischen Moduls 17 die ersten Rahmenteile 3 das innere Rohr 20, das von einem heißen Medium 22 durchströmt wird. Da das heiße Medium 22 regelmäßig ein Abgas ist, kann hier auf der Heißseite 31 auf eine elektrische Isolierung der ersten Rahmenteile 3 gegenüber dem Abgas verzichtet werden. Auf der Kaltseite 30 ist bei Verwendung eines elektrisch leitenden kalten Mediums 23 eine elektrische Isolierung 28 erforderlich, die außen auf den zweiten Rahmenteilen 4 aufgebracht ist. Diese kann beispielsweise als Schrumpfschlauch ausgebildet sein. Durch die nach außen bzw. innen aufstehenden Rahmenteile 3, 4 werden Kompensationselemente 27 gebildet, die eine Wärmeausdehnung des thermoelektrischen Moduls 17 in Richtung der Mittelachse 26 ermöglichen. Gleichzeitig wird auch eine relative Verschiebung der Halbleiterelemente 1 zueinander in einer radialen Richtung 32 ermöglicht.

Mit der hier vorliegenden Erfindung wurden die im Bezug auf den Stand der Technik geschilderten Probleme zumindest teilweise gelöst. Insbesondere wurde ein Halbleiterelement angegeben, das für vielseitige Einsatzfälle geeignet ist und das einen möglichst einfachen und kostengünstigen Aufbau eines thermoelektrischen Moduls ermöglicht. Dabei ist das hier für das erste Rahmenteil genannte ferritische Material auch ganz allgemein als elektrisch leitende Brücke zwischen Halbleiterelementen in thermoelektrischen Modulen einsetzbar, so dass dieses auch unabhängig vom Halbleitermaterial zur Anwendung gelangen kann.

### Bezugszeichenliste

- 1: Halbleiterelement
- 2: thermoelektrisches Material
- 3: erstes Rahmenteil
- 4: zweites Rahmenteil
- 5: innere Umfangsfläche
- 6: äußere Umfangsfläche
- 7: Fläche
- 8: Dicke
- 9: Anbindungsfläche
- 10: Kontaktfläche
- 11: Erste Breite
- 12: Zweite Breite
- 13: Seite
- 14: Beschichtung
- 15: Oberflächenstruktur
- 16: Element
- 17: thermoelektrisches Modul
- 18: Kontaktierung
- 19: Außenrohr
- 20: Innenrohr
- 21: Kanal
- 22: heißes Medium
- 23: kaltes Medium
- 24: thermoelektrisches Element
- 25: elektrisch leitende Brücke
- 26: Mittelachse
- 27: Kompensationselement
- 28: elektrische Isolierung
- 29: Elementfläche
- 30: Kaltseite
- 31: Heißseite
- 32: radiale Richtung

## Patentansprüche

1. Halbleiterelement (1) zumindest aufweisend ein thermoelektrisches Material (2) und ein erstes Rahmenteil (3), die kraftschlüssig miteinander verbunden sind, wobei das erste Rahmenteil (3) einen elektrischen Stromleiter bildet und aus einem ferritischem Stahl besteht; **dadurch gekennzeichnet dass** der ferritische Stahl zumindest folgende Legierungsbestandteile aufweist:
• höchstens 0,025 Gew.-% Kohlenstoff (C),
• 21 bis 24 Gew.-% Chrom (Cr),
• 0,7 bis 1,5 Gew.-% Molybdän (Mo),
• höchstens 1 Gew.-% Niob (Nb),
• höchstens 78,3 Gew.-% Eisen (Fe).

2. Halbleiterelement (1) gemäß Patentanspruch 1 mit einem zweiten Rahmenteil (4), das auf einer Elementfläche (29) des thermoelektrischen Materials (2) angeordnet ist, die der Elementfläche (29) gegenüberliegt, an der das erste Rahmenteil (3) angeordnet ist.

3. Halbleiterelement (1) nach Patentanspruch 2, wobei das thermoelektrische Material (2), das erste Rahmenteil (3) und das zweite Rahmenteil (4) ringförmig sind und das erste Rahmenteil (3) auf einer inneren Umfangsfläche (5) und das zweite Rahmenteil (4) auf einer äußeren Umfangsfläche (6) des thermoelektrischen Materials (2) angeordnet ist.

4. Halbleiterelement (1) gemäß einem der vorhergehenden Patentansprüche, wobei zumindest das erste Rahmenteil (3) zwei voneinander beabstandete gegenüberliegende Flächen (7) aufweist, wobei eine der Flächen (7) eine dem thermoelektrischen Material (2) zugewandte Anbindungsfläche (9) ist, wobei der Abstand der Flächen (7) voneinander eine Dicke (8) des ersten Rahmenteils (3) definiert, wobei die Dicke (8) 0,1 mm bis 1 mm beträgt.

5. Halbleiterelement (1) nach einem der vorhergehenden Patentansprüche, wobei zumindest das erste Rahmenteil (3) zwei voneinander beabstandete gegenüberliegende Kontaktflächen (10) aufweist, deren Abstand eine erste Breite (11) definiert, wobei die erste Breite (11) zumindest teilweise größer ist als eine zweite Breite (12) des thermoelektrischen Materials (2), so dass das erste Rahmenteil (3) an zumindest einer Seite (13) des thermoelektrischen Materials (2) übersteht.

6. Halbleiterelement (1) nach einem der vorhergehenden Patentansprüche, wobei zumindest das erste Rahmenteil (3) eine Beschichtung (14) aufweist, die zumindest auf der dem thermoelektrischen Material (2) zugewandten Anbindungsfläche (9) angeordnet ist.

7. Halbleiterelement (1) nach Anspruch 6, bei dem die Beschichtung (14) ein Lot umfasst.

8. Thermoelektrisches Modul (17), zumindest aufweisend Halbleiterelemente (1), die über elektrisch leitende Brücken (25) miteinander verbunden sind, so dass thermoelektrische Elemente (24) gebildet werden, wobei zumindest eine elektrisch leitende Brücke (25) einen ferritischen Stahl aufweist, **dadurch gekennzeichnet dass** bei die elektrisch leitende Brücken (25) einen ferritischen Stahl mit zumindest folgenden Legierungsbestandteilen aufweist:
• höchstens 0,025 Gew.-% Kohlenstoff (C),
• 21 bis 24 Gew.-% Chrom (Cr),
• 0,7 bis 1,5 Gew.-% Molybdän (Mo),
• höchstens 1 Gew.-% Niob (Nb),
• höchstens 78,3 Gew.-% Eisen (Fe).

## Claims

1. Semiconductor element (1) at least comprising a thermoelectric material (2) and a first frame part (3), which are connected to one another in a force-locking manner, wherein the first frame part (3) forms an electric current conductor and consists of a ferritic steel; **characterized in that** the ferritic steel comprises at least the following alloying constituents:
• at most 0.025% by weight of carbon (C),
• 21 to 24% by weight of chromium (Cr),
• 0.7 to 1.5% by weight of molybdenum (Mo),
• at most 1% by weight of niobium (Nb),
• at most 78.3% by weight of iron (Fe).

2. Semiconductor element (1) according to Patent Claim 1 comprising a second frame part (4), which is arranged on an element surface (29) of the thermoelectric material (2) that is situated opposite the element surface (29) on which the first frame part (3) is arranged.

3. Semiconductor element (1) according to Patent Claim 2, wherein the thermoelectric material (2), the first frame part (3) and the second frame part (4) are ring-shaped and the first frame part (3) is arranged on an inner circumferential surface (5) and the second frame part (4) is arranged on an outer circumferential surface (6) of the thermoelectric material (2).

4. Semiconductor element (1) according to any of the preceding patent claims, wherein at least the first frame part (3) has two opposite surfaces (7) spaced apart from one another, wherein one of the surfaces (7) is a linking surface (9) facing the thermoelectric material (2), wherein the distance between the surfaces (7) defines a thickness (8) of the first frame part (3), wherein the thickness (8) is 0.1 mm to 1 mm.

5. Semiconductor element (1) according to any of the preceding patent claims, wherein at least the first frame part (3) has two opposite contact surfaces (10) spaced apart from one another, the distance between which defines a first width (11), wherein the first width (11) is at least partly greater than a second width (12) of the thermoelectric material (2), such that the first frame part (3) projects at at least one side (13) of the thermoelectric material (2).

6. Semiconductor element (1) according to any of the preceding patent claims, wherein at least the first frame part (3) has a coating (14), which is arranged at least on the linking surface (9) facing the thermoelectric material (2).

7. Semiconductor element (1) according to Claim 6, wherein the coating (14) comprises a solder.

8. Thermoelectric module (17), at least comprising semiconductor elements (1) which are connected to one another via electrically conductive bridges (25), such that thermoelectric elements (24) are formed, wherein at least one electrically conductive bridge (25) comprises a ferritic steel, **characterized in that** the electrically conductive bridge (25) comprises a ferritic steel having at least the following alloying constituents:
• at most 0.025% by weight of carbon (C),
• 21 to 24% by weight of chromium (Cr),
• 0.7 to 1.5% by weight of molybdenum (Mo),
• at most 1% by weight of niobium (Nb),
• at most 78.3% by weight of iron (Fe).

## Revendications

1. Elément semi-conducteur (1) présentant au moins un matériau thermoélectrique (2) et une première partie d'encadrement (3) reliés l'un à l'autre en correspondance mécanique, la première partie d'encadrement (3) formant un conducteur de courant électrique et étant réalisée en un acier ferritique,
**caractérisé en ce que**
l'acier ferritique présente au moins les composants d'alliage suivants :
au plus 0,025 % en poids de carbone (C),
de 21 à 24 % en poids de chrome (Cr),
de 0,7 à 1,5 % en poids de molybdène (Mo),
au moins 1 % en poids de niobium (Nb) et
au plus 78,3 % en poids de fer (Fe).

2. Elément semi-conducteur (1) selon la revendication 1, présentant une deuxième partie d'encadrement (4) disposée sur une surface (29) du matériau thermoélectrique (2) de l'élément située face à la surface (29) de l'élément sur laquelle la première partie d'encadrement (3) est disposée.

3. Elément semi-conducteur (1) selon la revendication 2, dans lequel le matériau thermoélectrique (2), la première partie d'encadrement (3) et la deuxième partie d'encadrement (4) sont de forme annulaire, la première partie d'encadrement (3) étant disposée sur une surface périphérique intérieure (5) et la deuxième partie d'encadrement (4) sur une surface périphérique extérieure (6) du matériau thermoélectrique (2).

4. Elément semi-conducteur (1) selon l'une des revendications précédentes, dans lequel au moins la première partie d'encadrement (3) présente deux surfaces (7) mutuellement opposées et situées à distance l'une de l'autre, l'une des surfaces (7) étant la surface de liaison (9) tournée vers le matériau thermoélectrique (2) et la distance entre les surfaces (7) définissant l'épaisseur (8) de la première partie d'encadrement (3), l'épaisseur (8) étant comprise entre 0,1 mm et 1 mm.

5. Elément semi-conducteur (1) selon l'une des revendications précédentes, dans lequel au moins la première partie d'encadrement (3) présente deux surfaces de contact (10) mutuellement opposées et situées à une distance l'une de l'autre qui définit une première largeur (11), la première largeur (11) étant au moins en partie plus grande qu'une deuxième largeur (12) du matériau thermoélectrique (2), de telle sorte que la première partie d'encadrement (3) déborde sur au moins un côté (13) du matériau thermoélectrique (2).

6. Elément semi-conducteur (1) selon l'une des revendications précédentes, dans lequel au moins la première partie d'encadrement (3) présente un revêtement (14) disposé au moins sur la surface de liaison (9) tournée vers le matériau thermoélectrique (2).

7. Elément semi-conducteur (1) selon la revendication 6, dans lequel le revêtement (14) comporte une brasure.

8. Module thermoélectrique (17) présentant au moins des éléments semi-conducteurs (1) reliés les uns aux autres par des ponts électriquement conducteurs (25) de manière à former des éléments thermoélectriques (24), au moins un pont électriquement conducteur (25) présentant un acier ferritique, **caractérisé en ce que**
le pont électriquement conducteur (25) présentant un acier ferritique qui présente au moins les composants d'alliage suivants :
au plus 0,025 % en poids de carbone (C),
de 21 à 24 % en poids de chrome (Cr),
de 0,7 à 1,5 % en poids de molybdène (Mo),
au moins 1 % en poids de niobium (Nb) et
au plus 78,3 % en poids de fer (Fe).
